# EUROPEAN PATENT APPLICATION

(11) **EP 1 522 894 A2**
(43) Date of publication of application: **13.04.2005**
(21) Application number: 04023824.8
(22) Date of filing: 06.10.2004
(51) Int. Cl.: G03F 7/20

(54) **Semiconductor fabrication apparatus and pattern formation method using the same**

(30) Priority: 06.10.2003 JP 2003346938; 27.05.2004 JP 2004157011
(71) Applicant: MATSUSHITA ELECTRIC INDUSTRIAL CO., LTD., Kadoma-shi, Osaka 571-8501 (JP)
(72) Inventor: Endo, Masayuki, Kishiwada-shi, Osaka 596-0825 (JP); Sasago, Masaru, Hirakata-shi, Osaka 573-0007 (JP)
(74) Representative: Grünecker, Kinkeldey, Stockmair & Schwanhäusser Anwaltssozietät

(57) **Abstract**

The semiconductor fabrication apparatus of this invention includes an exposure section (30) provided within a chamber (10) for exposing a design pattern on a resist film applied on a wafer (20), and a liquid recycle section (40) for supplying, onto the wafer, a liquid (23) for use in immersion lithography for increasing the numerical aperture of exposing light during exposure while recycling the liquid. The liquid recycle section includes a liquid supply part (41) for supplying the liquid onto the resist film (21) of the wafer, a liquid discharge part (42) for discharging and recovering the liquid from above the wafer, and an impurity removal part (43) for containing the liquid and removing an impurity included in the liquid.

## Description

### BACKGROUND OF THE INVENTION

The present invention relates to a semiconductor fabrication apparatus for use in fabrication process and the like for semiconductor devices and a pattern formation method using the semiconductor fabrication apparatus.

In accordance with the increased degree of integration of semiconductor integrated circuits and downsizing of semiconductor devices, there are increasing demands for further rapid development of lithography technique. Currently, pattern formation is carried out through photolithography using exposing light of a mercury lamp, KrF excimer laser, ArF excimer laser or the like, and use of F₂ laser lasing at a shorter wavelength is being examined. However, since there remain a large number of problems in exposure systems and resist materials, photolithography using exposing light of a shorter wavelength has not been put to practical use.

In these circumstances, immersion lithography has been recently proposed for realizing further refinement of patterns by using conventional exposing light (see, for example, M. Switkes and M. Rothschild, "Immersion lithography at 157 nm", J. Vac. Sci. Technol., Vol. B19, p. 2353 (2001)).

In the immersion lithography, a region in an exposure system sandwiched between a projection lens and a resist film formed on a wafer is filled with a liquid having a refractive index **n** (wherein n > 1), and therefore, the NA (numerical aperture) of the exposure system has a value **n·NA.** As a result, the resolution of the resist film can be improved.

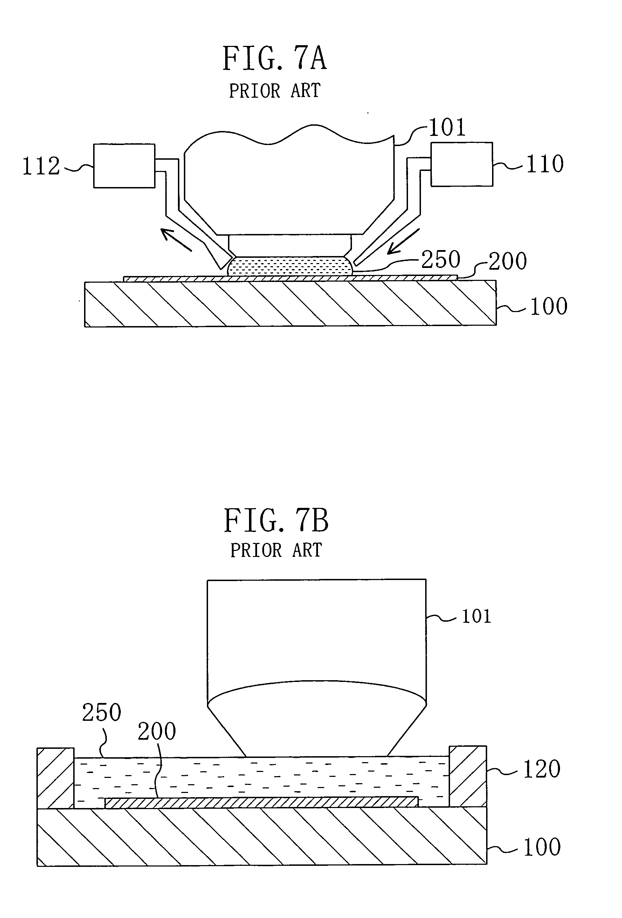

In a conventional immersion type exposure system, a liquid for immersion filled in a portion between an exposure section and a wafer face is supplied by one of two methods, for example, respectively shown in FIGS. 7A and 7B. In an exposure system shown in FIG. 7A employing what is called a dropping method, a liquid 250 is locally supplied to a portion between a wafer 200 placed on a stage 100 and an exposure section 101 so as to cover a portion of the wafer face corresponding to at least one shot of exposure. Specifically, exposure is performed with the liquid 250 supplied from a liquid supply section 110 onto the face of the wafer 200 immediately before one shot of exposure, and thereafter, the liquid 250 is discharged through a liquid discharge section 112 before the stage 100 moves to the next shot. In this manner, the supply and the discharge of the liquid 250 are repeated correspondingly to every shot of exposure in accordance with the sliding movement of the wafer 200 with the stage 100 along a scanning direction.

On the other hand, in an exposure system shown in FIG. 7B employing what is called a pooling method, a wafer 200 placed on a stage 100 is immersed in a bath 120 containing a liquid 250, and therefore, exposure is performed with the whole face of the wafer covered with the liquid 250. Furthermore, when the stage 100 is moved for the next shot after one shot of exposure, an exposure section 101 is moved to slide on the liquid level of the liquid 250.

In the conventional exposure system employing the immersion lithography, the liquid 250 provided between the wafer 200 and the exposure section 101 is discarded after the exposure whichever method is employed for supplying the liquid 250. In particular, in the exposure system employing the dropping method shown in FIG. 7A, since the liquid 250 is rapidly supplied and discharged for every shot of exposure, a large amount of liquid 250 is consumed.

Also, even in the case where the exposure system employing the pooling method shown in FIG. 7B is used, the liquid 250 should be periodically exchanged in mass production for performing the pattern exposure on hundreds of wafers 200 a day, and hence, a large amount of liquid 250 is also consumed.

### SUMMARY OF THE INVENTION

An object of the invention is solving the problem by performing pattern formation through the immersion lithography at low cost.

As described above, a large amount of liquid is consumed, the cost for the exposure is increased. In addition, it is necessary to subject the liquid to waste solution processing before it is discarded, and hence, the whole cost for the semiconductor fabrication is disadvantageously increased.

In order to achieve the object, in a semiconductor fabrication apparatus employing the immersion lithography and a pattern formation method using the same according to the present invention, a liquid provided between a resist film and an exposure section (a projection lens) for increasing the numerical aperture in the immersion lithography is recycled.

Specifically, the pattern formation method of this invention includes the steps of forming a resist film on a substrate; performing pattern exposure by selectively irradiating the resist film with exposing light with a liquid provided on the resist film; and forming a resist pattern by developing the resist film after the pattern exposure, and the liquid used in the step of performing pattern exposure is recycled.

In the pattern formation method of this invention, the recycled liquid is used as the liquid to be supplied between the resist film and an exposure section in the step of performing pattern exposure, and therefore, increase of cost of the exposure can be suppressed.

In the pattern formation method of this invention, the liquid is preferably recycled during the step of performing pattern exposure.

In the pattern formation method of this invention, the liquid is preferably recovered after the step of performing pattern exposure and recycled in next pattern exposure.

In the pattern formation method of this invention, the step of performing pattern exposure preferably includes a sub-step of removing an impurity mixed in the liquid. Thus, even when the liquid once used in the exposure is recycled, an impurity derived from a semiconductor fabrication apparatus or the resist film and mixed in the liquid during the exposure can be removed. Therefore, the recycled liquid attains, through the removal of the impurity, a purity substantially equivalent to that of a fresh liquid. Accordingly, even when the exposure is performed through the recycled liquid, the resist film can be definitely patterned.

The pattern formation method of this invention preferably further includes, a step of removing an impurity mixed in the liquid having been recovered.

The pattern formation method of this invention preferably further includes, before or after the step of performing pattern exposure, a step of removing an impurity mixed in the liquid.

In this case, the liquid is preferably allowed to pass through a filter in the step of removing an impurity. Furthermore, when a chemical filter is used as the filter, even if, for example, an alkaline or acidic chemical substance is eluted into the liquid from the resist film in contact with the liquid, the chemical substance can be definitely removed.

Also, the pattern formation method of this invention preferably further includes, after the step of removing an impurity, a step of checking a composition or an amount of the impurity included in the liquid.

Furthermore, the pattern formation method of this invention preferably further includes, after the step of performing pattern exposure, a degassing step of removing a gas included in the liquid. Thus, a gas (bubbles) included in the liquid can be removed, and therefore, scattering of the exposing light caused by bubbles included in the liquid can be prevented. Accordingly, a pattern can be formed in a good shape.

The semiconductor fabrication apparatus of this invention includes a pattern exposure section for performing exposure with a liquid provided between a resist film formed on a substrate and an exposure lens; a liquid supply section that is connected to the pattern exposure section in such a manner as to allow the liquid to flow to the pattern exposure section and supplies the liquid to the pattern exposure section; and an impurity removal part that is connected to the pattern exposure section in such a manner as to allow the liquid to flow to the pattern exposure section and removes an impurity included in the liquid, and the impurity removal part is connected to the liquid supply section in such a manner as to allow the liquid to flow to the liquid supply section and transfers, to the liquid supply section, the liquid from which the impurity has been removed.

In the semiconductor fabrication apparatus of this invention, since the liquid for immersion can be recycled because the liquid from which the impurity has been removed is transferred to the liquid supply section, increase of cost of the exposure using the liquid for immersion can be suppressed. In addition, the recycled liquid attains a purity substantially equivalent to that of a fresh liquid owing to the impurity removal part. Therefore, even when the exposure is performed through the recycled liquid, the resist film can be definitely patterned.

The semiconductor fabrication apparatus of this invention preferably further includes a liquid check part provided between the impurity removal part and the liquid supply section for checking a composition or an amount of the impurity included in the liquid to be transferred to the liquid supply section.

The semiconductor fabrication apparatus of this invention preferably further includes a first control section for controlling an amount of the liquid to be introduced from the pattern exposure section to the impurity removal part.

In the semiconductor fabrication apparatus of this invention, the liquid supply section preferably includes an addition part for adding an additive to the liquid; and a mix part for supplying, to the pattern exposure section, a fresh liquid, the liquid from which the impurity has been removed or the liquid including the additive having been adjusted.

In this case, the semiconductor fabrication apparatus preferably further includes a second control section for controlling an amount of the additive to be added from the addition part to the liquid in the mix part.

The semiconductor fabrication apparatus of this invention preferably further includes a degassing section provided between the liquid supply section and the pattern exposure section for removing a gas included in the liquid to be supplied to the pattern exposure section.

In the semiconductor fabrication apparatus of this invention, the impurity removal part preferably includes a filter for removing the impurity included in the liquid.

The impurity removed in the semiconductor fabrication apparatus of this invention is preferably particles or a chemical substance.

In this case, the chemical substance to be removed is amine, an acid or a low molecular-weight polymer.

The semiconductor fabrication apparatus of this invention preferably further includes a third control section for controlling an amount of the liquid through a first monitor provided between the pattern exposure section and the impurity removal part.

The semiconductor fabrication apparatus of this invention preferably further includes a fourth control section for controlling, through a second monitor provided in the mix part, at least one of an amount of the additive to be introduced to the mix part and an amount of the fresh liquid.

In the pattern formation method and the semiconductor fabrication apparatus of this invention, the liquid can be water or perfluoropolyether.

In the pattern formation method and the exposure system of this invention, exposing light can be KrF excimer laser, X₂ laser, ArF excimer laser, F₂ laser, KrAr laser or Ar₂ laser.

### BRIEF DESCRIPTION OF THE DRAWINGS

FIGS. **1A** and **1B** are diagrams of a semiconductor fabrication apparatus used in a pattern formation method employing immersion lithography according to Embodiment 1 of the invention, and more specifically, FIG. **1A** is a schematic cross-sectional view of a principal portion of the semiconductor fabrication apparatus and FIG. **1B** is a schematic perspective view of a liquid recycle section of the semiconductor fabrication apparatus;
FIG. **2** is a schematic cross-sectional view of a principal portion of a semiconductor fabrication apparatus according to a modification of Embodiment 1 of the invention;
FIGS. **3A, 3B, 3C** and **3D** are cross-sectional views for showing procedures including first exposure in the pattern formation method of Embodiment 1;
FIGS. **4A**, **4B** and **4C** are cross-sectional views for showing procedures including second exposure in the pattern formation method of Embodiment 1 of the invention;
FIG. **5** is a block diagram of a semiconductor fabrication apparatus for use in immersion lithography according to Embodiment 2 of the invention;
FIG. **6A** is a block diagram of a liquid supply section of the semiconductor fabrication apparatus of Embodiment 2 and FIG. 6B is a block diagram of a liquid recycle section of the semiconductor fabrication apparatus of Embodiment 2; and
FIG. **7A** is a cross-sectional view of a principal portion of a semiconductor fabrication apparatus for use in conventional immersion lithography employing a dropping method and FIG. **7B** is a cross-sectional view of a principal portion of a semiconductor fabrication apparatus for use in conventional immersion lithography employing a pooling method.

### DETAILED DESCRIPTION OF THE INVENTION

### EMBODIMENT 1

Embodiment 1 of the invention will now be described with reference to the accompanying drawings.

### (Semiconductor fabrication apparatus)

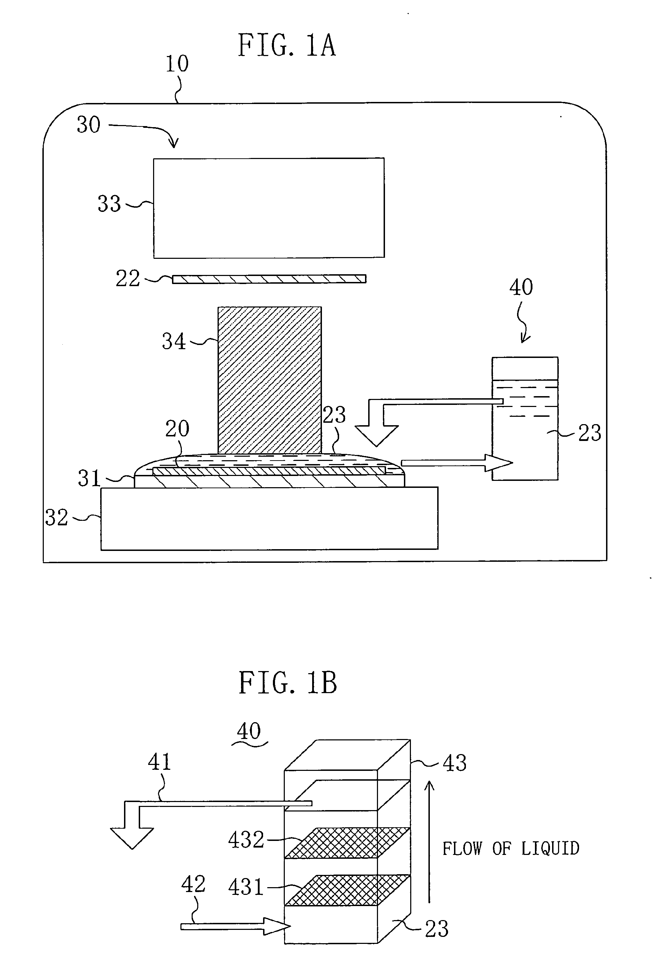

FIGS. **1A** and **1B** show a semiconductor fabrication apparatus used for realizing a pattern formation method employing immersion lithography according to Embodiment 1 of the invention, and more specifically, FIG. **1A** is a schematic cross-sectional view of a principal portion of the semiconductor fabrication apparatus and FIG. **1B** is a schematic perspective view of a liquid recycle section of the semiconductor fabrication apparatus.

As shown in FIG. **1A,** the semiconductor fabrication apparatus of Embodiment 1 includes an exposure section **30** that is provided within a chamber **10** for exposing a design pattern on a resist film (not shown) applied on a wafer **20**, and a liquid recycle section **40** that supplies a liquid **23**, which is used in the immersion lithography for increasing the numerical aperture of exposing light, onto the wafer **20** during the exposure while recycling the liquid **23**.

The exposure section **30** is composed of a wafer stage **31** for holding the wafer **20**, a surface plate **32** for holding the wafer stage **31**, an illumination system **33** provided above the wafer **20** and including an exposing light source opposing the wafer stage **31**, and a projection lens **34** provided between the illumination system **33** and the wafer stage **31** for projecting, onto the resist film through the liquid **23**, exposing light emitted from the illumination system **33** and entering through a mask (reticle) **22** having a design pattern to be transferred onto the resist film.

In this case, the projection lens **34** is held, during the exposure, so as to be in contact with the surface of the liquid **23** supplied onto the resist film of the wafer **20**.

The liquid recycle section **40** is composed of, as shown in FIGS. **1A** and **1B,** a liquid supply part **41** for supplying the liquid **23** onto the resist film of the wafer **20**, a liquid discharge part **42** for discharging and recovering the liquid **23** having been supplied onto the resist film after the exposure, and an impurity removal part **43** for containing the recovered liquid **23** and removing impurities included in the recovered liquid **23**.

Although not shown in the drawings, the impurity removal part **43** is provided with a supplying pump for supplying the liquid **23** onto the wafer **20** and a recovering pump for recovering the liquid **23** from above the wafer **20**.

Furthermore, since the impurities included in the recovered liquid **23** are not only particles but also, for example, chemical substances eluted from the resist film and the like, the impurity removal part **43** is provided with a mechanical filter (particle filter) **431** capable of filtering out the particles and a chemical filter **432** capable of filtering out the chemical substances.

Specific examples of the chemical substances are alkaline substances eluted from the resist film and its peripheral portion such as amines, ammonia and hexamethyldisilazane, an acid derived from an acid generator included in the resist film such as trifluoromethanesulfonic acid or nonafluorobutanesulfonic acid, an acidic substance such as sulfuric acid, and an outgas generated from the resist film.

In this manner, the semiconductor fabrication apparatus of this embodiment includes the liquid recycle section **40** that recovers the liquid **23** having been used in the immersion lithography and removes not only the particles included in the recovered liquid **23** but also the chemical substances such as the outgas eluted from the resist film during the exposure. Therefore, the purity of the liquid **23** of, for example, perfluoropolyether can be kept, and hence, the liquid **23** can be definitely recycled. As a result, increase of the exposure cost of the immersion lithography can be suppressed.

Although the mechanical filter **431** and the chemical filter **432** are both provided as the filters for removing the impurities in this embodiment, merely one of them may be used. However, in order to keep a high purity of the liquid **23**, both of the filters are preferably provided.

### (Modification of semiconductor fabrication apparatus)

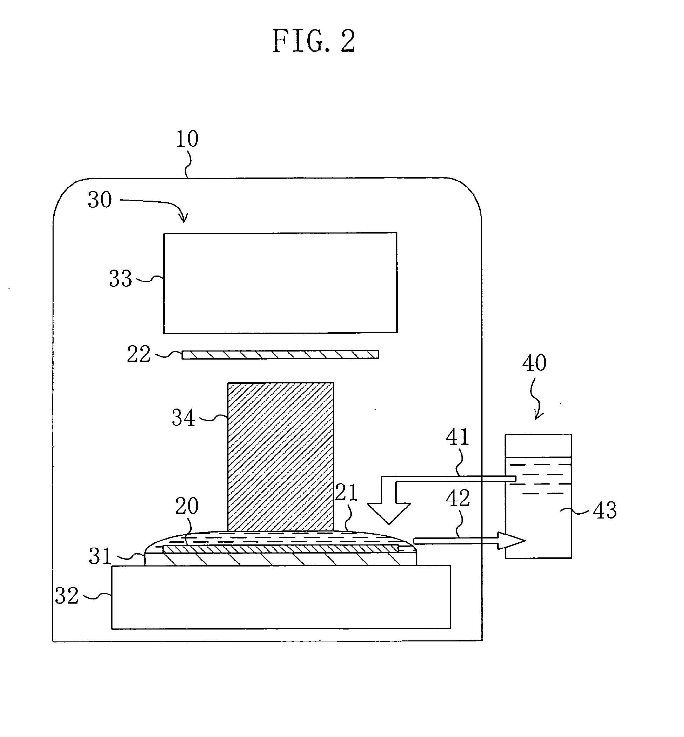

FIG. 2 shows a semiconductor fabrication apparatus according to a modification of Embodiment 1. In FIG. **2**, like reference numerals are used to refer to like elements shown in FIGS. **1A** and **1B** so as to omit the description.

As shown in FIG. **2**, in the semiconductor fabrication apparatus of this modification, the liquid recycle section **40** for supplying and recycling the liquid **23** for use in the immersion lithography is provided outside the chamber **10**. When the liquid recycle section **40** is thus provided outside the chamber **10**, the cleanness within the chamber **10** can be more highly kept.

### (Pattern formation method)

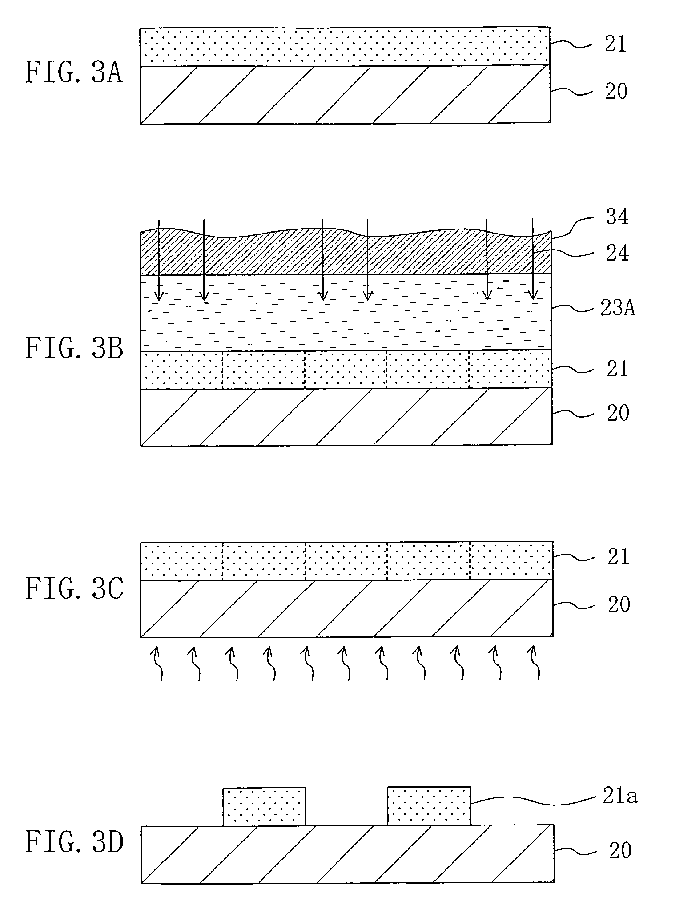

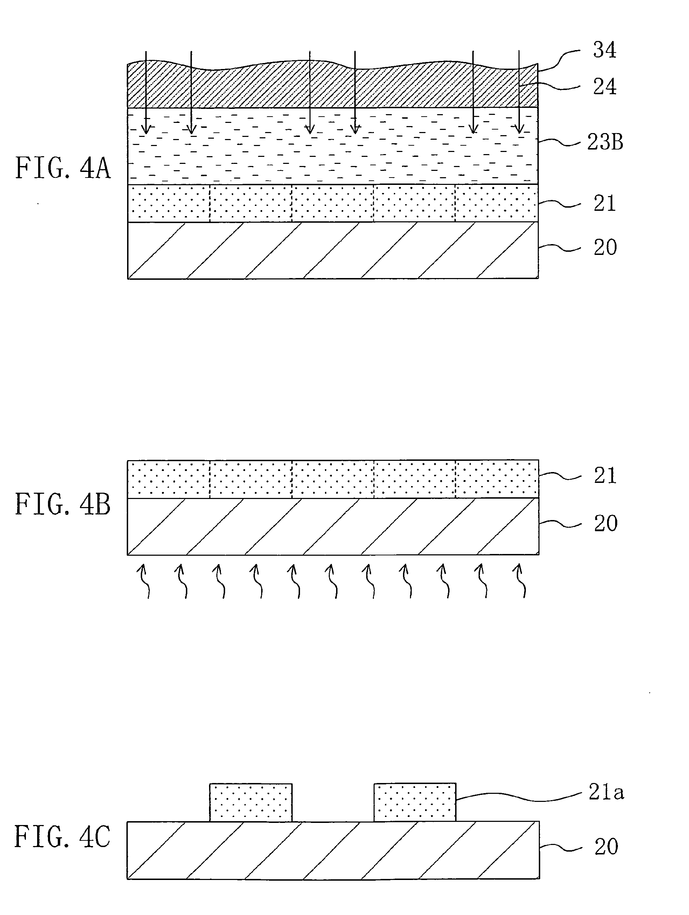

Now, a pattern formation method using the semiconductor fabrication apparatus having the aforementioned architecture will be described with reference to FIGS. **3A** through **3D** and **4A** through **4C**.

First, a positive chemically amplified resist material having the following composition is prepared:
Base polymer: poly((styrenehexafluoroisopropylalcohol) (40 mol%) - (α-trifluoromethyl t-butylacrylate) (60 mol%) 2 g
Acid generator: triphenylsulfonium triflate 0.08 g
Solvent: propylene glycol monomethyl ether acetate 20 g

Next, as shown in FIG. **3A,** the aforementioned chemically amplified resist material is applied on a wafer **20** so as to form a resist film **21** with a thickness of 0.20 µm.

Then, as shown in FIG. **3B**, while supplying a liquid **23A** of perfluoropolyether between the resist film **21** and a projection lens **34,** pattern exposure is carried out by irradiating the resist film **21** with exposing light **24** of F₂ laser with NA of 0.60 through a mask not shown.

After the pattern exposure, as shown in FIG. **3C,** the resist film **21** is baked with a hot plate at a temperature of 100°C for 60 seconds, and the resultant resist film is developed with a 2.38 wt% tetramethylammonium hydroxide aqueous solution (alkaline developer). In this manner, a resist pattern **21a** made of an unexposed portion of the resist film **21** and having a line width of 0.06 µm can be formed in a good shape as shown in FIG. **3D**.

Next, the liquid **23A** having been used in the exposure is recovered through, for example, the liquid discharge part **42** of FIG. **1B** to the impurity removal part **43,** and particles and chemical substances eluted from the resist film **21** are removed in the impurity removal part **43**.

Subsequently, as shown in FIG. **4A,** a liquid **23B** recycled from the liquid supply part **41** is provided between the projection lens **34** and a resist film **21** formed on the principal face of another wafer **20,** and the pattern exposure is performed by irradiating the resist film **21** with the exposing light **24** of F₂ laser with the numerical aperture **NA** of 0.60 through a mask not shown.

After this pattern exposure, as shown in FIG. **4B**, the resist film **21** is baked with a hot plate at a temperature of 100°C for 60 seconds, and the resultant resist film is developed with a 2.38 wt% tetramethylammonium hydroxide developer. In this manner, a resist pattern **21a** made of an unexposed portion of the resist film **21** and having a line width of 0.06 µm can be formed in a good shape with high reproducibility as shown in FIG. **4C**.

As described so far, according to Embodiment 1, the impurities are removed from the liquid **23A** recovered after the first exposure so as to reuse the resultant liquid as the liquid **23B** for the second exposure. Accordingly, while realizing fine patterns by the immersion lithography, the increase of the exposure cost derived from mass consumption of the liquid for the immersion lithography can be suppressed.

It is noted that the exposing light emitted from the light source included in the illumination system **33** is not limited to the F₂ laser in this embodiment, but any of KrF excimer laser, Xe₂ laser, ArF excimer laser, KrAr laser and Ar₂ laser may be appropriately used.

Furthermore, the liquids **23, 23A** and **23B** used for the immersion lithography may be water instead of perfluoropolyether.

### EMBODIMENT 2

Embodiment 2 of the invention will now be described.

Also in the conventional exposure system employing the pooling method shown in FIG. **7B,** it is necessary to periodically exchange the liquid **250** for immersion as described above. This is because a resist film deposited on the wafer **200** is always in contact with the liquid **250** during the exposure in portions other than exposed portions, and the contact area between the liquid **250** and the resist film is large and the contact time is long.

In general, a resist film is made from a mixture of a plurality of materials, and an acid is generated from the resist film during the exposure. Accordingly, even when the liquid **250** for immersion is difficult to dissolve the resist film, it is difficult to completely prevent the acid generated from the resist film and compounds included in the resist film from eluting into the liquid **250**. In other words, when the liquid **250** is continuously used for the exposure of a plurality of wafers **200**, the liquid **250** is disadvantageously contaminated by impurities mixed in it. When the purity of the liquid **250** for immersion is lowered due to the impurities, the exposing light emitted from the exposure section **101** may be scattered or partially absorbed by the impurities, so that exposure for irradiating an exposed portion of the wafer **200** may be largely varied. As a result, it is difficult to accurately perform the pattern exposure.

Therefore, in the case where the liquid **250** for immersion is recycled, it is necessary to restore the original purity of the liquid **250** by removing impurities and contaminants included in the recovered liquid **250**.

Now, a semiconductor fabrication apparatus according to Embodiment 2 of the invention will be described with reference to the accompanying drawings.

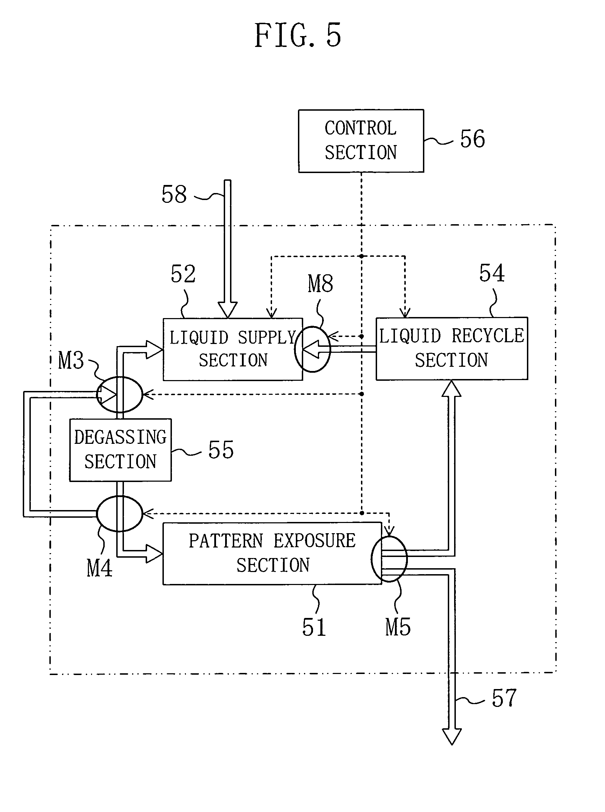

FIG. **5** is a block diagram of the semiconductor fabrication apparatus capable of practicing immersion lithography according to Embodiment 2 of the invention.

As shown in FIG. **5**, the semiconductor fabrication apparatus of Embodiment 2 includes a pattern exposure section **51** for exposing a desired pattern on a resist film deposited on a wafer, a liquid supply section **52** for supplying, to the pattern exposure section, a liquid for immersion to be provided between the resist film and a projection lens, and a liquid recycle section **54** for recovering the liquid having been used in the pattern exposure and discharged for supplying it again to the liquid supply section **52**.

The semiconductor fabrication apparatus further includes a degassing section (defoaming section) **55** for removing bubbles included in the liquid provided between the liquid supply section **52** and the pattern exposure section **51,** and a control section **56** for monitoring the supply amount and the recover amount of the liquid and for monitoring and controlling the purity of the liquid recovered in the liquid recycle section **54.** The pattern exposure section **51** is provided with a first discharge port **57** so that the liquid having been used in the exposure can be discharged.

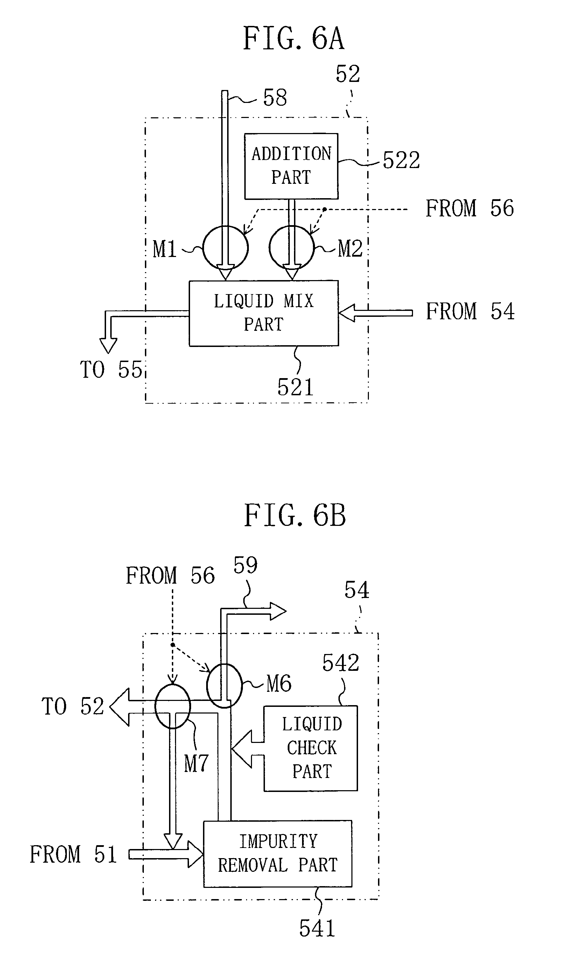

The architectures of the liquid supply section **52** and the liquid recycle section **54** are shown in FIGS. **6A** and **6B,** respectively.

The liquid supply section **52** includes, as shown in FIG. **6A**, a liquid mix part **521** and an addition part **522** for adding, to the liquid, an additive that can adjust the optical and electric characteristics of the liquid. A fresh liquid for immersion supplied through a supply port **58** and the liquid having been used in the exposure supplied from the liquid recycle section **54** are introduced into the liquid mix part **521**, to which a compound capable of adjusting the refractive index or the electric resistivity of the liquid, such as cesium sulfide (CsSO₄) or ethyl alcohol (C₂H₅OH), is added by the addition part **522** if necessary.

The liquid recycle section **54** includes, as shown in FIG. **6B,** an impurity removal part 541 for removing impurities mixed in the liquid recovered from the pattern exposure section **51**, and a liquid check part **542** for checking the purity of the liquid from which the impurities have been removed. The impurity removal part **541** is provided with a second discharge port **59** for discharging the liquid that is determined to be unsuitable for recycle as a result of the check performed by the liquid check part **542**.

Now, the operation of the semiconductor fabrication apparatus having the aforementioned architecture will be described.
(1) Operation performed from the supply port **58** to the liquid supply section **52**:
   First, as shown in FIG. **6A**, a liquid for immersion with a high purity, such as water (pure water) or perfluoropolyether, is introduced through the supply port **58** into the liquid mix part **521** of the liquid supply section **52** to be temporarily pooled therein. In the case where there is no need to add an additive to the liquid, the liquid with a high purity is supplied from the supply port **58** through the liquid supply section **52** to the pattern exposure section **51**.
   In the case where an additive is added to the liquid, an appropriate amount of additive is added to the liquid pooled in the liquid mix part **521** by the addition part **522**.
   At this point, the control section **56** of FIG. **5** adjusts, through a first monitor **M1** provided in the supply port **58**, the amount of fresh liquid for immersion (with a high purity) to be introduced into the liquid mix part **521**. Also, the control section **56** adjusts, through a second monitor M2 provided between the addition part **522** and the liquid mix part **521**, the amount of additive to be added to the liquid pooled in the liquid mix part **521**.
   In the case where the additive is added to the liquid, the liquid is homogeneously mixed with the additive in the liquid mix part **521**, and then, the resultant is supplied through the degassing section **55** to the pattern exposure section **51**.
(2) Operation performed from the liquid supply section **52** and the degassing section **55** to the pattern exposure section **51**:
   As shown in FIG. **5**, the liquid supplied from the liquid supply section **52** passes through the degassing section **55** before being supplied to the pattern exposure section **51**. The degassing section **55** removes bubbles included in the liquid supplied to the liquid supply section **52**. The bubbles are removed by any of known methods, such as a gas-liquid separating method, a nitrogen dissolving method and a gas-liquid separating film method. It is noted that the degassing section **55** is not always necessary but is preferably provided for removing bubbles generated or mixed in the liquid during the exposure.
   In the exposure employing the immersion lithography, if a liquid for immersion includes a large number of bubbles, exposing light is scattered by the bubbles. Also, since the bubbles have refractive indexes different from the liquid, the light refractive index is varied in the liquid between a portion having the bubbles and a portion having no bubbles. As a result, there arises a problem of pattern defective or the like.
   Accordingly, it is preferred that the liquid is checked for bubbles before the exposure so as to remove bubbles from the liquid supplied to the pattern exposure section **51** as far as possible. However, although it is difficult to completely remove bubbles from the liquid, the problem caused in the exposure due to the bubbles can be prevented by satisfying given reference points that the size (diameter) of each bubble is 0.1 µm or more and the number of bubbles is approximately 30 or less per 100 ml of the liquid.
   Therefore, in Embodiment 2, a third monitor **M3** and a fourth monitor **M4** are respectively provided to an inlet and an outlet of the degassing section **55**, so that the number of bubbles can be measured through the third monitor **M3** by the control section **56** by employing, for example, a laser scanning method before the liquid is supplied to the pattern exposure section **51**. In this embodiment, only when the sizes and the number of bubbles do not satisfy the aforementioned reference points, the liquid is subjected to degassing in the degassing section **55** so as to satisfy the reference points.
   Thereafter, before supplying the liquid for immersion to the pattern exposure section **51**, the state of the bubbles, such as the sizes and the number of bubbles, is measured through the fourth monitor **M4** again by employing, for example, the laser scanning method. When it is found as a result that the reference points are satisfied, the liquid is supplied to the pattern exposure section **51**, and when it is found that the reference points are not satisfied, the liquid is allowed to pass through the degassing section **55** again for further removing the bubbles. It is noted that the measurement result obtained by the third monitor **M3** and the fourth monitor **M4** and the control of the flow rate and the flow direction of the liquid are managed in a batch in accordance with control signals from the control section **56**.
(3) Operation performed from the pattern exposure section **51** to the liquid recycle section 54:
   As shown in FIG. **5**, the pattern exposure is performed in the pattern exposure section **51** by using the liquid for immersion that has been degassed in the degassing section **55** if necessary.
   After the pattern exposure, a part of the liquid is discharged through the first discharge port **57** and the remaining part thereof is recovered to the liquid recycle section **54** in accordance with the amount of impurities included in the liquid. Specifically, the amount of impurities included in the liquid after the exposure is checked through a fifth monitor **M5** provided on the discharge port of the pattern exposure section **51**. When the amount of impurities exceeds a given value, the liquid is discharged through the first discharge port **57**, and a portion of the liquid including the impurities in the amount not exceeding the given value is transferred to the liquid recycle section **54**. The control section **56** manages information about the amount of impurities obtained through the fifth monitor M5, so as to control the amount of liquid to be discharged through the first discharge port **57**. At this point, in the case where the amount of impurities included in the liquid after the exposure is less than the given value, the whole liquid is recovered to the liquid recycle section **54** without being discharged through the first discharge port **57**.
   For the exposure employing the immersion lithography, any of the dropping method and the pooling method can be employed. Also, when the pooling method is employed, the liquid contained in a bath may be recovered to the liquid recycle section **54** as a whole after the exposure of a plurality of wafers, or the liquid contained in the bath may be always circulated through the pattern exposure section **51,** the liquid recycle section **54** and the liquid supply section **52**.
   Next, the operation of the liquid recycle section **54** will be described.
   As shown in FIG. **6B,** the impurities included in the liquid for immersion recovered to the liquid recycle section **54** are first removed in the impurity removal part **541**. Specifically, particles that are fine dusts present in the exposure system, an outgas generated from the resist film and dissolved in the liquid during the exposure, basic components such as quenchers eluted from the resist film, and low molecular-weight polymers such as effusions like amines and an acid generated from an acid generator are removed from the recovered liquid.
   For removing the impurities, a filter with a mesh size of, for example, approximately 0.1 µm can be used for the particles. Also, a chemical filter or a combination of a column chromatography such as silica gel and activated carbon or the like can be used for contaminants derived from the resist film and the outgas.
   Thereafter, a part of the liquid from which the impurities have been removed is allowed to pass through the liquid check part **542** so as to check whether or not the liquid has a purity equivalent to the original purity.
   Specifically, the amount of particles and the amount of the other impurities included in the liquid for immersion, the temperature of the liquid, the electric resistivity and the refractive index of the liquid are checked, so as to be compared with corresponding values of a fresh liquid supplied through the supply port **58**. For example, with respect to the amount of particles, it is confirmed with a particle counter that the number of particles with a size of 0.1 µm or more is 30 or less per 100 ml of the liquid. Also, the amount of the impurities eluted from the resist film is measured with the ion chromatography, so as to confirm the amount of amine is 1 µg/m³ or less. With respect to the temperature of the liquid, it is confirmed that the temperature is equivalent to the room temperature (ranging from 15°C to 35°C and for example, of 23°C), and more specifically, the temperature is the room temperature ± 0.01°C. The conductivity of the liquid is measured with a conductivity meter, so as to confirm that the conductivity of the liquid is 0.06 µS/cm or less.
   A sixth monitor **M6** and a seventh monitor **M7** are provided between the impurity removal part **541** and the second discharge port 59. In the case where it is found, as a result of the check of the liquid having been used in the exposure, that the purity of the liquid is not sufficiently restored and it is determined through the sixth monitor **M6** that the purity cannot be restored to a given value by allowing the liquid to pass through the impurity removal part **541** again, such a liquid is discharged through the second discharge port **59**.
   On the contrary, in the case where it is determined through the sixth monitor **M6** that the liquid can be recycled, the liquid is checked again through the seventh monitor **M7** whether or not it has a purity equivalent to that of a fresh liquid. At this point, if the purity of the liquid is determined to be insufficient, the liquid is returned to the impurity removal part **541** again, so as to remove the impurities in the impurity removal part **541**. The control section **56** receives check information of the impurities from the sixth monitor M6 and the seventh monitor **M7**, and controls the amount of liquid to be discharged through the second discharge port **59**, the amount of liquid to be returned to the impurity removal part **541**, the amount of liquid to be supplied to the liquid supply section **52** and the like.
   Thereafter, after confirming that the liquid has attained a purity equivalent to that of a fresh liquid by passing through the circular cycle of the impurity removal part **541** and the liquid check part **542**, the liquid whose purity has been thus confirmed is transferred from the liquid recycle section **54** to the liquid supply section **52**.
(4) Operation performed from the liquid recycle section **54** to the liquid supply section **52**:
   As shown in FIG. **5**, the liquid for immersion transferred from the liquid recycle section **54** to the liquid supply section **52** is checked for its amount through an eighth monitor **M8** provided between the liquid recycle section **54** and the liquid supply section **52**. Information of the amount of liquid transferred from the liquid recycle section **54** to the liquid supply section **52** is managed by the control section **56**, so as to determine the amount of fresh liquid to be additionally supplied through the supply port **58** in accordance with the amount of recycled liquid. Thereafter, as described with reference to FIG. **6A**, the control section **56** determines the amount of fresh liquid to be additionally supplied, the amount of liquid to be supplied from the liquid recycle section **54** and the amount of additive to be used for adjusting the refractive index and the like, so as to control the amount and the quality of the liquid necessary to be supplied to the pattern exposure section **51**.
   As described so far, in Embodiment 2, the liquid recycle section **54** that is connected to the pattern exposure section **51** so as to allow the liquid for immersion to flow thereto and is capable of recovering the liquid having been used in the exposure and removing the impurities included in the recovered liquid is also connected to the liquid supply section **52** for supplying the liquid for immersion to the pattern exposure section **51**. Accordingly, the liquid for immersion having been used in the exposure can be transferred to the liquid supply section **52** for recycle, and therefore, cost increase of the semiconductor fabrication apparatus using the liquid can be suppressed.
   In addition, the liquid for immersion to be recycled attains a purity substantially equivalent to that of a fresh liquid owing to the impurity removal part **541** included in the liquid recycle section **54**. Therefore, even when the recycled liquid is used for the exposure, resist films can be satisfactorily patterned.
   In Embodiment 2, the liquid for immersion can be supplied onto the wafer by any of the dropping method and the pooling method.
   Although the semiconductor fabrication apparatus of Embodiment 2 includes the eight monitors of the first through the eighth monitors **M1** through **M8,** all of these monitors are not necessary and some of them may be appropriately provided.
   The light source of exposing light may be appropriately selected from F₂ laser, KrF excimer laser, Xe₂ laser, ArF excimer laser, KrAr laser and Ar₂ laser.
   In this manner, the present invention has an effect to realize, at low cost, a fine pattern in a good shape formed through the immersion lithography, and is useful as a semiconductor fabrication apparatus for use in the fabrication process and the like for semiconductor devices and a pattern formation method using the semiconductor fabrication apparatus.

## Claims

1. A pattern formation method comprising the steps of:
forming a resist film on a substrate;
performing pattern exposure by selectively irradiating said resist film with exposing light with a liquid provided on said resist film;
developing said resist film after the pattern exposure; and
recycling said liquid used in the step of performing pattern exposure.

2. The pattern formation method of Claim 1,
wherein said liquid provided on said resist film comprises at least one of a fresh liquid, said recycled liquid, or a combination of said fresh liquid and said recycled liquid.

3. The pattern formation method of Claim 1,
wherein said liquid is recycled during the next pattern exposure.

4. The pattern formation method of Claim 1,
wherein the recycling step has a sub-step of removing an impurity from the liquid.

5. The pattern formation method of Claim 4,
wherein said liquid passes through a filter in the sub-step of removing an impurity.

6. The pattern formation method of Claim 4, further comprising, after the sub-step of removing an impurity, a step of checking at least one of a composition and an amount of said impurity included in said liquid.

7. The pattern formation method of Claim 3, further comprising a step of removing an impurity mixed in said liquid having been recovered after the pattern exposure.

8. The pattern formation method of Claim 7,
wherein said liquid passes through a filter in the step of removing an impurity.

9. The pattern formation method of Claim 7, further comprising, after the step of removing an impurity, a step of checking at least one of a composition and an amount of said impurity included in said liquid.

10. The pattern formation method of Claim 1, further comprising, before or after the step of performing pattern exposure, a step of removing an impurity mixed in said liquid.

11. (Amended) The pattern, formation method of Claim 10,
wherein said liquid passes through a filter in the step of removing an impurity.

12. (Amended) The pattern formation method of Claim 10, further comprising, after the step of removing an impurity, a step of checking at least one of a composition and an amount of said impurity included in said liquid.

13. The pattern formation method of Claim 1, further comprising, after the step of performing pattern exposure, a degassing step of removing a gas included in said liquid.

14. The pattern formation method of Claim 1,
wherein said liquid is water or perfluoropolyether.

15. The pattern formation method of Claim 1,
wherein said exposing light is KrF excimer laser, X₂ laser, ArF excimer laser, F₂ laser, KrAr laser or Ar₂ laser.

16. A semiconductor fabrication apparatus comprising:
a unit for providing a liquid between a resist film formed on a substrate and an exposure lens;
a liquid supply section coupled to said unit to provide said liquid to said unit; and
a recycling unit coupled to said unit for receiving said liquid from said unit and for purifying said liquid,
wherein said recycling unit is coupled to said liquid supply section to transfer said purified liquid to said liquid supply section.

17. The semiconductor fabrication apparatus of Claim 16, further comprising a test unit provided between said recycling unit and said liquid supply section having an analyzer to check at least one of a composition and an amount of an impurity included in said purified liquid output by said recycling unit.

18. The semiconductor fabrication apparatus of Claim 16, further comprising a first control section for controlling the amount of said purified liquid output by the recycling unit to be provided to the liquid supply section.

19. The semiconductor fabrication apparatus of Claim 16,
wherein said liquid supply section includes:
an addition unit for providing an additive to said liquid; and
a mixing unit for combining a fresh liquid, and said purified liquid from which said impurity has been removed or said purified liquid including said additive.

20. The semiconductor fabrication apparatus of Claim 19, further comprising a second control section having a system control for determining an amount of said additive to be added from said addition unit to said purified liquid.

21. The semiconductor fabrication apparatus of Claim 16, further comprising a degassing section provided between said liquid supply section and said pattern exposure section, for removing a gas included in said liquid to be supplied to said unit.

22. The semiconductor fabrication apparatus of Claim 16,
wherein said impurity removal unit having a filter for removing said impurity included in said liquid.

23. The semiconductor fabrication apparatus of Claim 16,
wherein said impurity is particles or a chemical substance.

24. The semiconductor fabrication apparatus of Claim 23,
wherein said chemical substance is amine, an acid or a low molecular-weight polymer.

25. The semiconductor fabrication apparatus of Claim 16, further comprising a third control section having a system to control an amount of said liquid through a first monitor provided between said pattern exposure section and said impurity removal unit.

26. The semiconductor fabrication apparatus of Claim 19, further comprising a fourth control section having a system to control, through a second monitor provided in said mixing unit, at least one of an amount of said additive to be introduced to said mixing unit and an amount of said fresh liquid.

27. The semiconductor fabrication apparatus of Claim 16,
wherein said liquid is water or perfluoropolyether.

28. The semiconductor fabrication apparatus of Claim 16,
wherein said exposure section uses, as exposing light, KrF excimer laser, X₂ laser, ArF excimer laser, F₂ laser, KrAr laser or Ar₂ laser.

29. The semiconductor fabrication apparatus of Claim 16, said unit is placed in a pattern exposure section.

30. A semiconductor fabrication apparatus comprising:
a unit to provide a liquid between a resist film formed on a substrate and an exposure lens;
a liquid supply section that is connected to said unit to provide said liquid for said unit;
a degas section provided between said liquid supply section and said unit to remove a gas included in a liquid provided from said liquid supply section,
an impurity removal unit that is connected to said unit to remove an impurity included in said liquid flowed from said unit,
wherein said impurity removal unit is connected to said liquid supply section to transfer a liquid from which said impurity has been removed, for said liquid supply section.

31. The semiconductor fabrication apparatus of Claim 30, further comprising a test unit provided between said impurity removal unit and said liquid supply section having analyzer to check a composition or an amount of said impurity included in said liquid transferred from said unit.

32. The semiconductor fabrication apparatus of Claim 30,
wherein said liquid supply section includes:
an addition unit for providing an additive to said liquid; and
a mixing unit for mixing up a fresh liquid, said liquid from which said impurity has been removed or said liquid including said additive having been adjusted.

33. The semiconductor fabrication apparatus of Claim 30,
wherein said impurity removal unit having a filter for removing said impurity included in said liquid.

34. The semiconductor fabrication apparatus of Claim 30, further comprising a third control section having a system to control an amount of said liquid through a first monitor provided between said unit and said impurity removal unit.

35. The semiconductor fabrication apparatus of Claim 32, further comprising a fourth control section having a system to control, through a second monitor provided in said mixing unit, at least one of an amount of said additive to be introduced to said mixing unit and an amount of said fresh liquid.

36. The pattern formation method of Claim 1,
wherein the substrate and the resist formed thereon are fully submerged in the liquid during the pattern exposure.

37. The semiconductor fabrication apparatus of Claim 16,
wherein the substrate and the resist formed thereon are fully submerged in the liquid in an exposure section having the exposure lens.

38. The semiconductor fabrication apparatus of Claim 30,
wherein the substrate and the resist formed thereon are fully submerged in the liquid in an exposure section having the exposure lens.

39. The pattern formation method of Claim 1,
wherein the liquid is only deposited on a surface of the resist during the pattern exposure.

40. The semiconductor fabrication apparatus of Claim 16,
wherein the liquid is only deposited on a surface of the resist at an exposure section having the exposure lens.

41. The semiconductor fabrication apparatus of Claim 30,
wherein the liquid is only deposited on a surface of the resist at an exposure section having the exposure lens.
